# EUROPÄISCHE PATENTANMELDUNG

(11) **EP 3 410 140 A1**
(43) Veröffentlichungstag der Anmeldung: **05.12.2018**
(21) Anmeldenummer: 17173231.6
(22) Anmeldetag: 29.05.2017
(51) Int. Cl.: G01R 31/40

(54) **VORRICHTUNG ZUM BELASTEN EINER ELEKTRISCHEN LEISTUNGSQUELLE**

(71) Anmelder: MAGNA STEYR Fahrzeugtechnik AG & Co KG, 8041 Graz (AT)
(72) Erfinder: PESSL, Benjamin, 8020 Graz (AT)
(74) Vertreter: Zangger, Bernd

(57) **Zusammenfassung**

Eine Vorrichtung zum Belasten einer elektrischen Leistungsquelle (1), umfassend einen Eingang (2) zur Abnahme der Leistung der elektrischen Leistungsquelle (1) und einen Ausgang (3) zur zumindest teilweisen Einspeisung der abgenommenen Leistung in ein Stromnetz (4), wobei die Vorrichtung einen elektrischen Energiespeicher (5) zur zumindest teilweisen Speicherung der abgenommenen Leistung umfasst, einen AC/DC Konverter (6) oder einen DC/DC Konverter am Eingang (2) und einen DC/AC Konverter (7) am Ausgang, sowie ein Verfahren zum Prüfen einer Ladestation für Elektrofahrzeuge mittels einer solchen Vorrichtung.

## Beschreibung

### Gebiet der Erfindung

Die vorliegende Erfindung betrifft eine Vorrichtung zum Belasten einer elektrischen Leistungsquelle und ein Verfahren zum Prüfen einer Ladestation für Elektrofahrzeuge mittels einer solchen Vorrichtung.

### Stand der Technik

Eine Vorrichtung zum Belasten einer elektrischen Leistungsquelle, auch "elektronische Last" genannt, ist ein Gerät oder eine Baugruppe, die als Ersatz für einen konventionellen, insbesondere ohmschen Lastwiderstand (Eingangswiderstand, Abschlusswiderstand, Außenwiderstand) eingesetzt werden kann. Als Gegenstück zur Stromquelle handelt es sich bei der elektronischen Last um eine Stromsenke. Oft ist ein Laststrom der elektronischen Last in einem definierten Bereich einstellbar.

Die von einer derartigen elektronischen Last aufgenommene elektrische Leistung wird meistens in Wärme umgewandelt, zur Kühlung und Abführung der Abwärme werden Lüfter oder flüssigkeitsgekühlte Elemente verwendet. Dies erfordert einerseits leistungsfähige Kühlkonzepte, um die dauerhafte Leistungsaufnahme durch den Lastsimulator gewährleisten zu können. Andererseits sind umfangreiche Schutz- und technische Maßnahmen wie z. B. ein ausreichend bemessener Sicherheitsabstand zu Kühlrippen und ein leistungsfähiges Kühlsystem, vorzusehen. Die Leistungsfähigkeit derartiger elektronischer Lasten ist im Allgemeinen stark begrenzt, da bei dissipativen Konzepten die Wärmeenergie nur mit großem Aufwand hinreichend schnell abgeführt werden kann.

Auch eine Rückspeisung der abgenommenen Leistung in ein öffentliches Stromversorgungsnetz ist unter bestimmten Voraussetzungen möglich und an sich bekannt.

Elektronische Lasten werden in verschiedensten Applikationen eingesetzt, vor allem zur Prüfung von Netz- und Steuergeräten, Batterien, Brennstoff- und Solarzellen. Derartige elektronische Lasten, die für physikalische Tests an elektrischen Komponenten benutzt werden, werden auch "Lastsimulatoren" genannt. Sie dienen dazu, elektrische Leistungssenken oder auch zeitweise Leistungsquellen, über welche im fertigen Produkt elektrische Leistung übertragen wird, nachzubilden, um an eben diesen Komponenten und Systemen physische Tests außerhalb ihrer angedachten Einsatzumgebung durchführen zu können. Dies ist im Entwicklungsprozess in vielen Fällen zwingend erforderlich.

Bekannt sind auch Ladestationen für Elektrofahrzeuge (die selbstverständlich auch für Hybridfahrzeuge verwendet werden können), die dazu dienen, die in derartigen Fahrzeugen als Antriebsbatterien verwendeten Hochvoltbatterien wieder aufzuladen. Solche Ladestationen arbeiten mit hohen Leistungen, die die Kapazität üblicher elektronischer Lasten übersteigt.

### Zusammenfassung der Erfindung

Es ist eine Aufgabe der Erfindung, eine Vorrichtung zum Belasten einer elektrischen Leistungsquelle anzugeben, die auch zur Prüfung von Hochleistungsquellen wie zum Beispiel von Ladestationen für Hochvoltbatterien geeignet ist und ein Verfahren zu Prüfen von Ladestationen mittels einer solchen Vorrichtung.

Die Lösung der Aufgabe erfolgt durch eine Vorrichtung zum Belasten einer elektrischen Leistungsquelle, umfassend einen Eingang zur Abnahme der Leistung der elektrischen Leistungsquelle und einen Ausgang zur zumindest teilweisen Einspeisung der abgenommenen Leistung in ein Stromnetz, wobei die Vorrichtung einen elektrischen Energiespeicher zur zumindest teilweisen Speicherung der abgenommenen Leistung umfasst, einen AC/DC Konverter oder einen DC/DC Konverter am Eingang und einen DC/AC Konverter am Ausgang.

Erfindungsgemäß wird eine Vorrichtung vorgeschlagen, die dazu ausgelegt ist auch hohe Lasten aufzunehmen, insbesondere von einer Wechselspannungsquelle und die diese aufgenommen Lasten auch zumindest teilweise in ein Versorgungsnetz rückspeisen kann. Dazu wird ein elektrischer Energiespeicher als Zwischenspeicher genutzt und eine Leistungselektronik, nämlich ein AC/DC Wandler oder für Gleichspannungsquellen ein DC/DC Wandler, innerhalb der Vorrichtung und vor dem elektrischen Energiespeicher angeordnet um den abgenommenen Strom auf die für den Energiespeicher erforderliche Stromart und Strom-Spannungs-Kombination zu transformieren. Auch am Ausgang der erfindungsgemäßen Vorrichtung, nämlich vor einer Rückspeisung in ein Stromnetz, ist ein DC/AC Wandler als Leistungselektronik vorgesehen.

Die Verlustwärme die bei üblichen elektronischen Lasten produziert wird, wird in dieser Lösung drastisch reduziert. Dadurch kann ein vorzugsweise auch in der erfindungsgemäßen Lösung vorgesehenes Kühlsystem deutlich kleiner dimensioniert werden, was wiederum zu einer geringerer räumlichen Ausdehnung der Vorrichtung führt. Darüber hinaus kann durch eine erfindungsgemäße Vorrichtung die Leistungsfähigkeit des Lastsimulators stark erhöht werden. Gleichzeitig kann ein Großteil der elektrisch zugeführten Energie einer konservativen bzw. produktiven Nutzung zugeführt werden und dissipiert nicht. Durch all diese Eigenschaften kann das Einsatzspektrum von Lastsimulatoren auf viele Anwendungen in beispielsweise der Elektromobilität ausgeweitet werden, insbesondere für Hochleistungs-Ladestationen für Elektrofahrzeuge.

Die Erfindung beschreibt somit einen elektrischen Lastsimulator, der dazu in der Lage ist, deutlich höhere Leistungen aufzunehmen als konventionelle Lastsimulatoren, und mit dem ein Großteil der zugeführten Energie weiterhin für unterschiedliche Anwendungen genutzt werden kann.

Vorzugsweise ist der elektrische Energiespeicher eine Hochvoltbatterie oder ein Superkondensator.

Bevorzugt umfasst die Vorrichtung auch einen Elektrolyseur, wobei durch den Elektrolyseur die abgenommene Leistung zumindest teilweise zur Erzeugung von Wasserstoff verwendet wird.

Die Vorrichtung umfasst auch vorzugsweise einen Wasserstofftank, insbesondere in Verbindung mit dem Elektrolyseur, so dass der in der Vorrichtung produzierte Wasserstoff im Wasserstofftank gespeichert werden kann.

Besonders bevorzugt umfasst die Vorrichtung auch ein Brennstoffzellensystem zur Umwandlung von Wasserstoff in elektrische Energie.

Die Vorrichtung kann insbesondere dazu ausgebildet sein, die durch das Brennstoffzellensystem erzeugte elektrische Energie zumindest teilweise in den elektrischen Energiespeicher zu laden.

Alternativ oder zusätzlich kann die Vorrichtung einen Anschluss an ein Erdgasnetz aufweisen, zur Einspeisung von Wasserstoff in ein Erdgasnetz.

Ein erfindungsgemäßes Verfahren zum Prüfen einer Ladestation für Elektrofahrzeuge sieht vor, dass der Eingang einer erfindungsgemäßen Vorrichtung als Last an die Ladestation angeschlossen wird und das Verhalten der Ladestation bei dieser Belastung gemessen wird. Die Prüfung der Ladestation erfolgt daher nach Anschluss einer erfindungsgemäßen Vorrichtung zum Belasten einer elektrischen Leistungsquelle, nämlich in diesem Fall zum Belasten der Ladestation.

### Kurzbeschreibung der Zeichnungen

Die Erfindung wird im Folgenden beispielhaft unter Bezugnahme auf die Zeichnungen beschrieben.
- Fig. 1: ist eine schematische Darstellung einer erfindungsgemäßen Vorrichtung zum Belasten einer elektrischen Leistungsquelle.
- Fig. 2: ist eine schematische Darstellung einer erfindungsgemäßen Vorrichtung zum Belasten einer elektrischen Leistungsquelle in einer umfangreichen Variante.

### Detaillierte Beschreibung der Erfindung

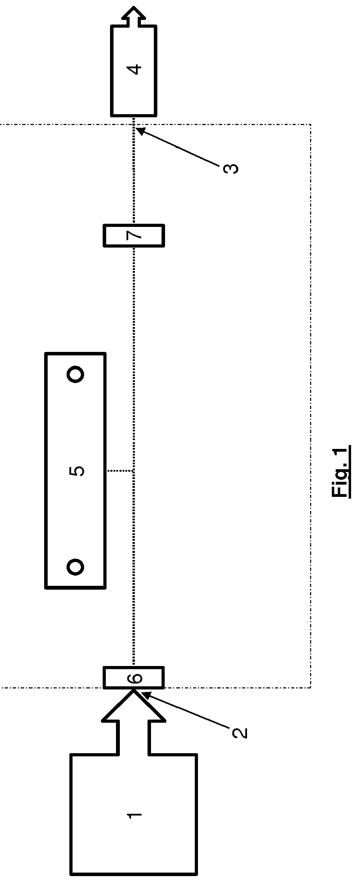

In Fig. 1 ist eine erfindungsgemäße Vorrichtung zum Belasten einer elektrischen Leistungsquelle 1, auch Lastsimulator genannt, innerhalb eines strich-punktierten Rahmens dargestellt. Die Vorrichtung umfasst einen Eingang 2 zur Abnahme der Leistung der elektrischen Leistungsquelle 1 und einen Ausgang 3 zur zumindest teilweisen Einspeisung der abgenommenen Leistung in ein Stromnetz 4, insbesondere ein öffentliches Stromversorgungsnetz, sowie einen elektrischen Energiespeicher 5 zur zumindest teilweisen Speicherung der abgenommenen Leistung, einen AC/DC Konverter 6 am Eingang, vor dem elektrischen Energiespeicher 5, so dass als elektrische Leistungsquelle 1 eine Wechselstromquelle verwendet werden kann. Am Ausgang 3 der Vorrichtung ist, innerhalb der Vorrichtung, ein DC/AC Konverter 7 dem elektrischen Energiespeicher 5 nachgeschaltet, so dass die abgenommene Leistung zumindest teilweise in ein Wechselstrom-Netzwerk 4 eingespeist werden kann.

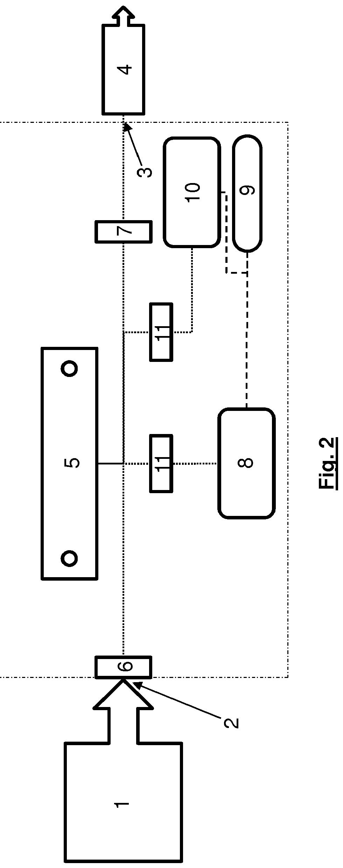

In Fig. 2 ist eine umfangreichere Variante einer solchen Vorrichtung zum Belasten einer elektrischen Leistungsquelle 1 dargestellt. Diese Vorrichtung umfasst:
- Leistungselektronik, nämlich AC/DC oder DC/DC Konverter 6 am Eingang 2 als Interface zur angeschlossenen Leistungsquelle 1,
- elektrisches Speichersystem 5, insbesondere Batterie bzw. Superkondensator oder ähnliches,
- ein nicht in der Fig. dargestelltes Kühlsystem,
- Leistungselektronik, nämlich DC/AC Konverter 7 zur Kopplung an das Stromnetz 4,
- Wasserstoff-Elektrolyseur 8 und Wasserstoff-Speichereinheit, nämlich Wasserstofftank 9,
- Wasserstoff-Brennstoffzellensystem 10,
- Optional kann auch die Abwärme genutzt werden, zum Beispiel über einen thermoelektrischen Generator zur Erzeugung elektrischer Leistung.

Die Eingangsleistung wird über die Leistungselektronik, AC/DC Konverter 6 (oder DC/DC Konverter 6) in den Lastsimulator eingebracht und damit auf die geeignete Stromart und Strom-Spannungs-Kombination gebracht. Ein nachgeschaltetes Speichersystem 5 dient der Aufnahme der umgewandelten Eingangsleistung. Die darin gespeicherte Energie kann nun erfindungsgemäß über einen DC/AC Konverter 7 in das Stromnetz 4 eingespeist werden.

Alternativ oder auch ergänzend kann die Energie dazu genutzt werden, beispielsweise über einen DC/DC Konverter 11, einen Elektrolyseur 8 zu betreiben, mit welchem Wasserstoff erzeugt wird. Beliebige Kombinationen aus Einspeisung in das Stromnetz und Nutzung der Energie für die Elektrolyse sind darstellbar. Der hergestellte Wasserstoff kann in einem Speichersystem 9 zwischengespeichert werden.

Eine weitere Möglichkeit ist die Einspeisung des erzeugten Wasserstoffs in ein Erdgasnetz.

Als weitere Option kann der Lastsimulator erfindungsgemäß ein Wasserstoff-Brennstoffzellensystem 10 beinhalten, welches aus dem zuvor hergestellten Wasserstoff wieder elektrische Leistung erzeugt. Diese kann, bevorzugt über einen DC/DC Konverter 11, wiederum in den elektrischen Energiespeicher 5 geladen werden, sodass der Lastsimulator auch über einen längeren Zeitraum als Leistungsquelle für zu testende Komponenten dienen kann, nicht nur als Leistungssenke. Durch diese Möglichkeit wird das Einsatzspektrum der erfindungsgemäßen Vorrichtung erhöht.

Als mögliches, bevorzugtes Einsatzszenario können Hochleistungs-Ladestationen für Elektrofahrzeuge genannt werden. Um diese eingehend prüfen zu können, muss deren volle Leistungsfähigkeit auch über einen längeren Zeitraum ausgeschöpft werden können. Dafür müssen mitunter Leistungen von bis zu mehreren hundert Kilowatt und Energiemengen ähnlicher Größenordnung in Kilowattstunden aufgenommen werden können. Abgesehen von der dafür erforderlichen Leistungsfähigkeit als technische Herausforderung können auch die Kosten für die abgezogene Energie ein signifikanter Faktor für die Wirtschaftlichkeit über die gesamte Einsatzdauer sein. Müssen jährlich zehntausende Kilowattstunden ungenutzt dissipiert werden, können hierdurch merkliche Kosten entstehen. Mithilfe der vorliegenden erfindungsgemäßen Vorrichtung kann ein Großteil der Energie wieder genutzt werden, was sich neben den Kosten auch auf die Umweltbilanz auswirkt.

### Bezugszeichenliste

- 1: elektrische Leistungsquelle
- 2: Eingang
- 3: Ausgang
- 4: Stromnetz
- 5: elektrischer Energiespeicher
- 6: AC/DC Konverter
- 7: DC/AC Konverter
- 8: Elektrolyseur
- 9: Wasserstofftank
- 10: Brennstoffzellensystem
- 11: DC/DC Konverter

## Patentansprüche

1. Vorrichtung zum Belasten einer elektrischen Leistungsquelle (1), umfassend einen Eingang (2) zur Abnahme der Leistung der elektrischen Leistungsquelle (1) und einen Ausgang (3) zur zumindest teilweisen Einspeisung der abgenommenen Leistung in ein Stromnetz (4),
**dadurch gekennzeichnet, dass** die Vorrichtung einen elektrischen Energiespeicher (5) zur zumindest teilweisen Speicherung der abgenommenen Leistung umfasst, einen AC/DC Konverter (6) oder einen DC/DC Konverter am Eingang (2) und einen DC/AC Konverter (7) am Ausgang.

2. Vorrichtung nach Anspruch 1,
**dadurch gekennzeichnet, dass** der elektrische Energiespeicher (5) eine Hochvoltbatterie ist oder ein Superkondensator.

3. Vorrichtung nach zumindest einem der vorhergehenden Ansprüche,
**dadurch gekennzeichnet, dass** die Vorrichtung einen Elektrolyseur (8) umfasst, wobei durch den Elektrolyseur (8) die abgenommene Leistung zumindest teilweise zur Erzeugung von Wasserstoff verwendet wird.

4. Vorrichtung nach zumindest einem der vorhergehenden Ansprüche,
**dadurch gekennzeichnet, dass** die Vorrichtung einen Wasserstofftank (9) umfasst.

5. Vorrichtung nach zumindest einem der vorhergehenden Ansprüche,
**dadurch gekennzeichnet, dass** die Vorrichtung ein Brennstoffzellensystem (10) umfasst zur Umwandlung von Wasserstoff in elektrische Energie.

6. Vorrichtung nach Anspruch 5,
**dadurch gekennzeichnet, dass** die Vorrichtung dazu ausgebildet ist, die durch das Brennstoffzellensystem (10) erzeugte elektrische Energie zumindest teilweise in den elektrischen Energiespeicher (5) zu laden.

7. Vorrichtung nach zumindest einem der vorhergehenden Ansprüche,
**dadurch gekennzeichnet, dass** die Vorrichtung einen Anschluss an ein Erdgasnetz aufweist zur Einspeisung von Wasserstoff in das Erdgasnetz.

8. Verfahren zum Prüfen einer Ladestation für Elektrofahrzeuge, wobei der Eingang (2) einer Vorrichtung nach zumindest einem der vorhergehenden Ansprüche als Last an die Ladestation angeschlossen wird und das Verhalten der Ladestation bei dieser Belastung gemessen wird.
